# EUROPEAN PATENT APPLICATION

(11) **EP 2 254 156 A2**
(43) Date of publication of application: **24.11.2010**
(21) Application number: 09717953.5
(22) Date of filing: 05.03.2009
(51) Int. Cl.: H01L 31/042, H01L 31/052

(54) **PHOTOVOLTAIC ASSEMBLY**

(30) Priority: 06.03.2008 KR 20080020998; 15.10.2008 KR 20080101198; 15.01.2009 KR 20090003285
(71) Applicant: Seo, Dae Ho, Gwangju 500-040 (KR); Jung, Seung Yeon, Gwangju 501-220 (KR)
(72) Inventor: Seo, Dae Ho, Gwangju 500-040 (KR); Jung, Seung Yeon, Gwangju 501-220 (KR)
(74) Representative: Kuhnen & Wacker
(86) International application number: PCT/KR2009/001101
(87) International publication number: WO 2009/110757

(57) **Abstract**

Provided is a photovoltaic cell assembly that effectively collects light and dissipates heat to improve electricity generating efficiency. The photovoltaic cell assembly includes a light collecting unit configured to collect sunlight incident from a Fresnel lens, a cell receiver configured to convert the sunlight collected by the light collecting unit to an electrical signal, a heat dissipation plate configured to support the light collecting unit and the cell receiver and fixed to an inner surface of a housing, and a heat dissipation block disposed on an outer surface of the housing and coupled to the heat dissipation plate with the housing interposed between the heat dissipation plate and the heat dissipation block.

## Description

### BACKGROUND ART

### Field of the Invention

The present invention relates to a photovoltaic cell assembly, and more particularly, to a photovoltaic cell assembly that effectively collects light and dissipates heat to improve electricity generating efficiency.

### Description of the Related Art

In general, a photovoltaic (PV) cell directly converts incident sunlight to electrical energy. Such photovoltaic cells using non-polluting and unlimited solar energy do not require an additional fuel and are considered as eco-friendly apparatuses without causing air pollution and wastes. Also, photovoltaic cells are semiconductor devices that almost do not cause mechanical vibration and noise.

In recent years, as the world's energy problems become serious, photovoltaic cells are actively developed with much interest. In photovoltaic cells, sunlight is directly incident to multi cells without reflection or refraction. Also, light collecting type photovoltaic cells include a reflector in front of multi cells to collect sunlight.

However, a light collecting type photovoltaic cell has a lower electricity generating efficiency than that of a photovoltaic cell that directly receives sunlight. This is because a power output efficiency of a light collecting type photovoltaic cell is multiplied by a transmissivity or reflectivity value.

That is, when a power conversion efficiency of a cell, which is a ratio of an electricity generating efficiency to an incident sunlight output, is about 15%, if a transmissivity or reflectivity value is about 90%, an electricity generating efficiency of a light collecting type photovoltaic cell is calculated as follows: 15% × 90% = 13.5%, which is substantially a low value.

Thus, as a method for obtaining a high power conversion efficiency, a Fresnel lens is installed on the upper side of a cell to collect incident sunlight to the cell with 500 times or greater intensity.

However, since sunlight is collected with 500 times or greater intensity on a single cell, the temperature of the cell quickly increases, on the contrary, the power conversion efficiency is degraded.

Thus, to decrease the quickly increased temperature of the cell, a heat dissipation plate having a plurality of fins is attached to a case that protects the cell from an external force. However, since the plate dissipates heat from the entire region of a photovoltaic cell, the plate is insufficient to decrease the temperature of the cell in the photovoltaic cell.

### Summary of the Invention

An object of the present invention is to provide a photovoltaic cell assembly having an improved heat dissipation performance.

Another object of the present invention is to provide a photovoltaic cell assembly that can efficiently collect sunlight incident through a lens.

According to an aspect of the present invention, there is provided a photovoltaic cell assembly including: a light collecting unit configured to collect sunlight incident from a Fresnel lens; a cell receiver configured to convert the sunlight collected by the light collecting unit to an electrical signal; a heat dissipation plate configured to support the light collecting unit and the cell receiver and fixed to an inner surface of a housing; and a heat dissipation block disposed on an outer surface of the housing and coupled to the heat dissipation plate with the housing interposed between the heat dissipation plate and the heat dissipation block.

The cell receiver may include: a cell configured to convert the sunlight to the electrical signal; a pair of diodes configured to rectify the electrical signal converted at the cell; a pair of connectors configured to output the rectified electrical signal to an outside; and a substrate to which the cell and the diode are mounted and the connector is fixed.

The substrate may be configured by bonding a semiconductor substrate and a metal substrate to each other. The semiconductor substrate may be formed of ceramic, and the metal substrate may be formed of copper.

A heat dissipation pad may be interposed or heat conducting grease may be applied between the heat dissipation plate and the housing and between the housing and the heat dissipation block.

An accommodation recess may be formed in a center of an upper surface of the heat dissipation plate, and the cell receiver may be accommodated in the accommodation recess. A plurality of guides may be disposed in a center of an upper surface of the heat dissipation plate and protrude at positions corresponding to edges of the cell receiver, and the cell receiver may be disposed in a region formed by the guides.

Flanges may be disposed at a lower end of the light collecting unit and protrude outward from both sides of the light collecting unit, and clamps may respectively overlap upper portions of the flanges, and the clamp may be fixed to the heat dissipation plate through a bolt.

Flanges may be disposed at a lower end of the light collecting unit and protrude outward from both sides of the light collecting unit, and clamps may respectively overlap upper portions of the flanges, and the clamp may be fixed to the heat dissipation plate through a bolt, and one of the clamps may cover and press the connector and an electric wire connected to the connector.

A plurality of guides may be disposed in a center of an upper surface of the heat dissipation plate and protrude at positions corresponding to edges of the cell receiver, and the cell receiver may be disposed in a region formed by the guides, and flanges may be disposed at a lower end of the light collecting unit and protrude outward from both sides of the light collecting unit, and the flanges may be supported respectively by supports disposed between the flanges and the heat dissipation plate, and clamps may respectively overlap upper portions of the flanges, and the clamp may be fixed to the heat dissipation plate through a bolt.

According to another aspect of the present invention, there is provided a photovoltaic cell assembly including: a light collecting unit configured to collect sunlight incident from a Fresnel lens; a cell receiver configured to convert the sunlight collected by the light collecting unit to an electrical signal; a heat dissipation plate configured to support the light collecting unit and the cell receiver; and a heat dissipation block integrally formed with the heat dissipation plate and disposed outside a housing, wherein the heat dissipation plate and the heat dissipation block each includes a body and a plurality of heat dissipation fins protruding from the body, and a size of the heat dissipation plate is smaller than a size of the heat dissipation block, and the heat dissipation plate is fitted in an opening having a size corresponding to the size of the heat dissipation plate and formed in the housing such that the heat dissipation block is fixed to the housing.

The heat dissipation fin of the heat dissipation plate may extend in a radial direction about the cell receiver, and the heat dissipation fin of the heat dissipation block may be formed in a lattice shape at a portion corresponding to the cell receiver.

A plurality of bolt holes may be arrayed along an edge of the heat dissipation block, and the heat dissipation block may be fixed to the housing through a bolt fitted from an inner surface of the housing to the bolt hole.

The photovoltaic cell assembly may further include heat dissipation fins extending outward from side surfaces of the heat dissipation block.

The heat dissipation block may be thickest at a portion corresponding to the cell receiver, and decrease in thickness toward both edges from the portion corresponding to the cell receiver.

A through hole may pass through side surfaces constituting the heat dissipation block and facing each other, a heat pipe may be inserted in the through hole, and a heat dissipation fin may be attached to a portion constituting the heat pipe and exposed from the through hole.

The heat dissipation plate may include a body having a portion that supports the cell receiver and is thicker than a rest portion, and the heat dissipation block may include a body having a plurality of steps that are formed from an edge, and the body is thickest at a portion corresponding to the cell receiver.

The heat dissipation fins of the heat dissipation plate and the heat dissipation block may decrease in thickness toward ends of the heat dissipation fins. The heat dissipation fins of the heat dissipation plate and the heat dissipation block may have surfaces with concave and convex structures.

The light collecting unit may include: a barrel-shaped first light collecting part fixed onto the cell receiver; and a second light collecting part extending from the first light collecting part to the lens, wherein an expansion angle of the second light collecting part from an optical axis of the lens is greater than that of the first light collecting part.

A focus of the lens may be disposed in a boundary between the first and second light collecting parts.

The expansion angle of the second light collecting part may range from about 28° to about 30° from the optical axis.

The light collecting unit may include: a barrel-shaped first light collecting part increasing in horizontal cross section from a lower end to an upper end along a first inclination angle; and a barrel-shaped second light collecting part bonded to the upper end of the first light collecting part and increasing in horizontal cross section along a second inclination angle greater than the first inclination angle.

The light collecting unit may include: a tetragonal barrel-shaped first light collecting part increasing in horizontal cross section from a lower end to an upper end along a first inclination angle; and a second light collecting part integrally extending respectively from surfaces at the upper end of the first light collecting part at a second inclination angle greater than the first inclination angle.

The light collecting unit may include: a barrel-shaped first light collecting part increasing in horizontal cross section from a lower end to an upper end along a first inclination angle; and a barrel-shaped second light collecting part extending from the upper end of the first light collecting part and increasing in horizontal cross section along a second inclination angle greater than the first inclination angle, wherein the first and second light collecting parts form a single body.

The light collecting unit may include: a barrel-shaped first light collecting part increasing in horizontal cross section from a lower end to an upper end along a first inclination angle; and a barrel-shaped second light collecting part extending from the upper end of the first light collecting part and increasing in horizontal cross section along a second inclination angle greater than the first inclination angle, wherein the first and second light collecting parts form a single body, and a total reflection occurs between inner and outer surfaces of the first and second light collecting parts.

The first and second light collecting parts may be formed of glass, and the inner surfaces respectively of the first and second light collecting parts may have higher refractivity values than those of the outer surfaces.

According to further another aspect of the present invention, there is provided a photovoltaic cell assembly including: a light collecting unit configured to collect sunlight incident from a Fresnel lens; a cell receiver configured to convert the sunlight collected by the light collecting unit to an electrical signal; a heat sink block including an upper body configured to support the light collecting unit and the cell receiver, and a lower body integrally formed with the upper body and disposed outside a housing; and a heat pipe coupled to the heat sink block and provided with a plurality of heat dissipation fins that are spaced a constant distance from one other and are fitted in and fixed to the heat pipe, wherein a size of the upper body is smaller than a size of the lower body, and the upper body is fitted in an opening having a size corresponding to the size of the upper body and formed in the housing such that the heat sink block is fixed to the housing.

### Brief Description of the Drawings

The above objects and other advantages of the present invention will become more apparent by describing in detail preferred embodiments thereof with reference to the attached drawings in which:

FIG. 1 is an exploded perspective view illustrating a photovoltaic cell assembly according to an embodiment of the present invention;

FIG. 2 is a cross-sectional view illustrating the photovoltaic cell assembly of FIG. 1;

FIG. 3 is a schematic view illustrating a clamp according to an embodiment of the present invention;

FIG. 4 is a cross-sectional view illustrating a photovoltaic cell assembly including a light collecting unit according to an embodiment of the present invention;

FIG. 5 is a perspective view illustrating a light collecting unit according to an embodiment of the present invention;

FIG. 6 is a perspective view illustrating a light collecting unit according to another embodiment of the present invention;

FIG. 7 is a perspective view illustrating a light collecting unit according to another embodiment of the present invention;

FIG. 8 is a perspective view illustrating a cell receiver fixing structure according to an embodiment of the present invention;

FIG. 9 is a cross-sectional view illustrating a heat dissipation module according to an embodiment of the present invention;

FIG. 10 is a cross-sectional view illustrating a heat dissipation module according to a modified example of FIG. 9;

FIG. 11 is a perspective view illustrating a heat dissipation module according to an embodiment of the present invention;

FIGS. 12A and 12B are schematic views illustrating heat dissipation fins of a heat dissipation plate and heat dissipation fins of a heat dissipation block according to an embodiment of the present invention;

FIG. 13 is a cross-sectional view illustrating the heat dissipation module of FIG. 11 coupled with a housing;

FIG. 14 is a perspective view illustrating a heat dissipation module according to another embodiment of the present invention;

FIG. 15 is a perspective view illustrating a heat dissipation module according to another embodiment of the present invention;

FIG. 16 is a perspective view illustrating a heat dissipation module according to another embodiment of the present invention; and

FIG. 17 is a perspective view illustrating a modified example of FIG. 16.

### Detailed Description of the preferred Embodiments

Now, preferred embodiments of the present invention will be described in detail with reference to the accompanying drawings.

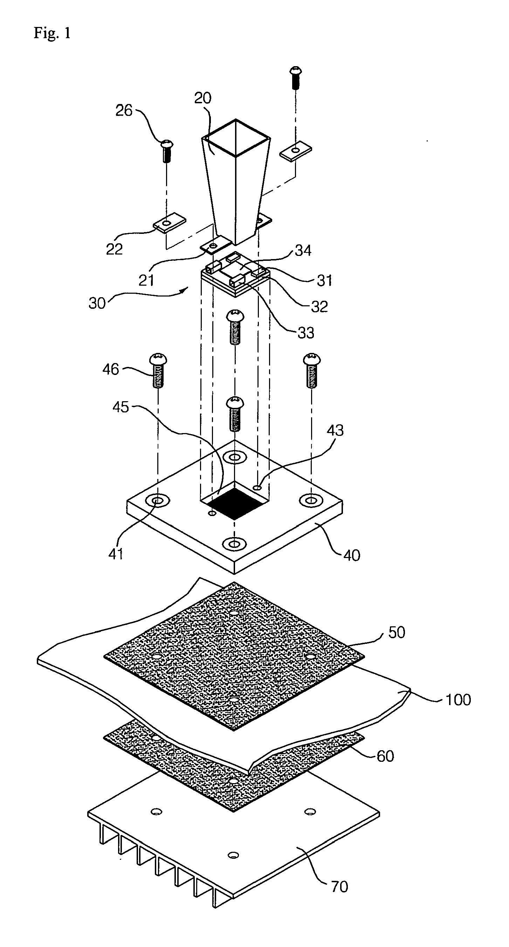

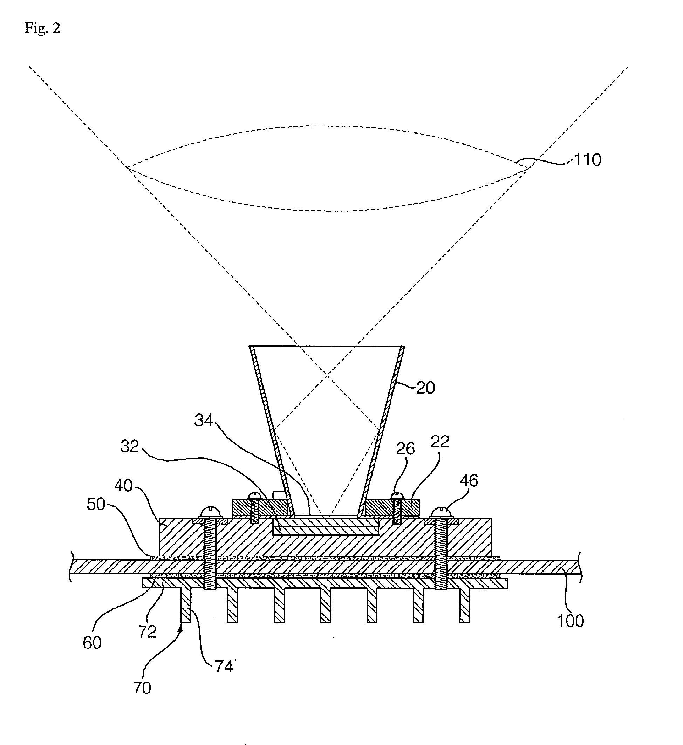

FIG. 1 is an exploded perspective view illustrating a photovoltaic cell assembly according to an embodiment of the present invention. FIG. 2 is a cross-sectional view illustrating the photovoltaic cell assembly of FIG. 1.

Referring to FIG. 1, a heat dissipation pad 50 is disposed on an inner surface of a housing 100, and a heat dissipation plate 40 is stacked on the heat dissipation pad 50. An accommodation recess 45 is formed in the center side of the heat dissipation plate 40, and a substrate 32 of a cell receiver 30 is accommodated in the accommodation recess 45. A solar cell 34 is mounted on the substrate 32. The solar cell 34 is surrounded by a light collecting unit 20, and receives light collected by the light collecting unit 20 and converts the light to electrical energy.

A heat dissipation pad 60 corresponding to the heat dissipation pad 50 is attached to the outer surface of the housing 100, and a heat dissipation block 70 is stacked on the heat dissipation pad 60.

In this state, the heat dissipation plate 40 is coupled with the heat dissipation block 70 through a member such as bolts 46, so that the photovoltaic cell assembly is fixed to the bottom surface of the housing 100.

Light collecting unit 20

The light collecting unit 20 reflects sunlight intensively incident through a Fresnel lens 110 (refer to FIG. 2) to collect the sunlight. The light collecting unit 20 is formed of a metal such as aluminum having high heat dissipation efficiency against a high temperature due to collected light, and has a hopper shape decreasing in diameter downward.

The light collecting unit 20 may be fixed to the substrate 32 of the cell receiver 30 by clamps 22. In detail, flanges 21 are disposed at the lower end of the light collecting unit 20 and protrude outward from both sides of the light collecting unit 20, and the clamps 22 overlap the upper portions of the flanges 21, respectively. In this state, the light collecting unit 20 is fixed to the substrate 32 through bolts 26. For example, the clamps 22 may be formed of aluminum having excellent heat dissipation efficiency.

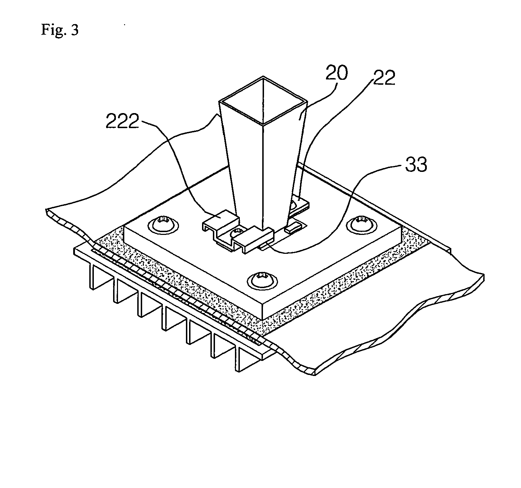

The clamps 22 are not limited in shape. Referring to FIG. 3, one (also denoted by 222) of the clamps 22 may have a shape to cover and press a pair of connectors 33 and electric wires coupled to the connectors 33. This structure fixes the light collecting unit 20 and securely couples the electric wires with the connectors 33.

For example, the light collecting unit 20 may have a structure to efficiently collect sunlight incident through a lens.

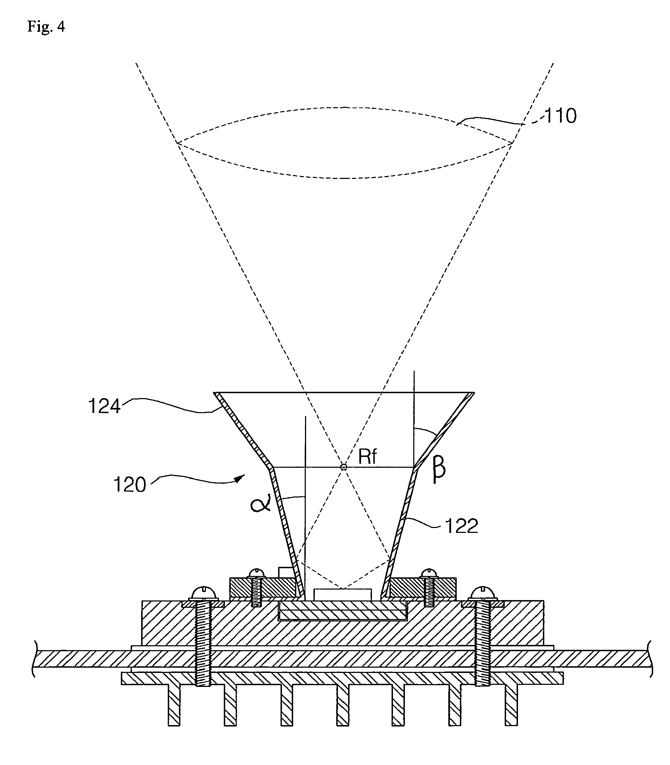

FIG. 4 is a cross-sectional view illustrating a photovoltaic cell assembly including a light collecting unit 120 according to an embodiment of the present invention.

Referring to FIG. 4, the light collecting unit 120 includes a first light collecting part 122 fixed to the upper portion of the substrate 32, and a second light collecting part 124 expanding and extending at an angle from the first light collecting part 122.

The first light collecting part 122 has a barrel shape with open upper and lower ends, for example, a tetragonal barrel shape, and is fixed to the upper portion of the substrate 32 of the cell receiver 30, and expands at an inclination angle α from an optical axis of the Fresnel lens 110.

The second light collecting part 124 extends from the upper end of the first light collecting part 122, and expands at an inclination angle β from the optical axis of the Fresnel lens 110, and the inclination angle β is greater than the inclination angle α.

For example, the boundary between the first and second light collecting parts 122 and 124 may be formed in a horizontal plane in which a focus Rf of the Fresnel lens 110 is formed.

The inclination angle β may be varied according to sizes and focus lengths of the Fresnel lens 110. For example, the inclination angle β may range from about 28° to about 30°.

From sunlight incident through the Fresnel lens 110 in this structure, both spread light and light of a wavelength, which cannot be collected in the related art, can be collected, and thus, output efficiency of the solar cell can be improved.

An actual application shows that a light collecting unit having the above-described structure has an output efficiency value greater by about 20% or more than a light collecting unit having a single inclination angle in the related art.

In addition, since a light collecting unit including a low-efficiency and inexpensive Fresnel lens in the above-described structure has similar output efficiency to that of a light collecting unit including a high-efficiency and expensive Fresnel lens in the related art, manufacturing costs can be reduced.

Moreover, even when a high-efficiency and expensive Fresnel lens has the above-described structure, an output is increased by about 5% or more.

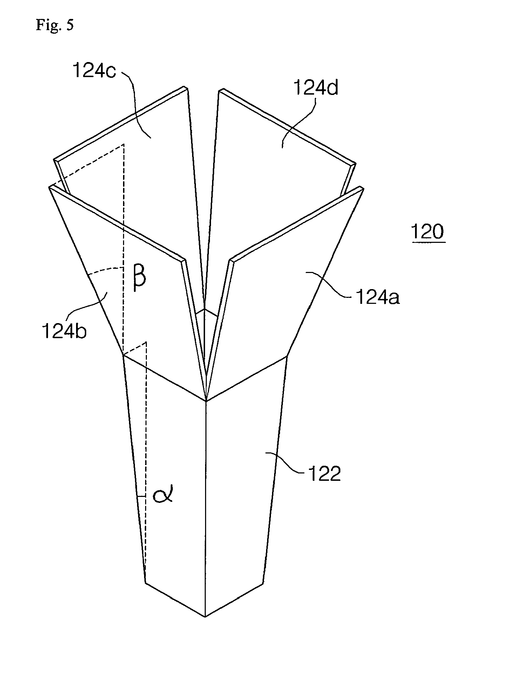

The light collecting unit 120 can be manufactured using various methods, a part of which is illustrated in FIGS. 5 through 7.

Referring to FIG. 5, the light collecting unit 120 includes the first light collecting part 122 having a tetragonal barrel shape in which a horizontal cross-section increases along the first inclination angle α from the lower end to the upper end, and second light collecting parts 124a, 124b, 124c, and 124d. The second light collecting parts 124a, 124b, 124c, and 124d each is integrally formed with the first light collecting part 122, and extends at the second angle β greater than the first inclination angle α from the upper end of the first light collecting part 122.

The light collecting unit 120 is formed by bending a single sheet to manufacture a light collecting unit having a tetragonal barrel shape with the first inclination angle α, and then, by cutting each edge at a predetermined height and bending each side surface outward to have the second inclination angle β.

The above-described structure facilitates manufacturing of the light collecting unit 120.

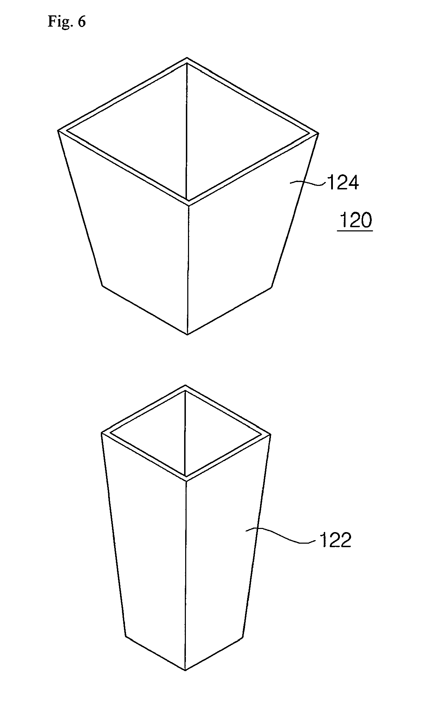

Referring to FIG. 6, the first light collecting part 122 has a barrel shape in which a horizontal cross-section increases from the lower end to the upper end, and the second light collecting part 124 is bonded to the upper end of the first light collecting part 122, and has a barrel shape in which a horizontal cross-section increases along a second angle greater than a first inclination angle.

The structure of FIG. 6 can be manufactured by separately manufacturing the first and second light collecting parts 122 and 124, and then, by bonding the second light collecting part 124 to the upper end of the first light collecting part 122 through a method such as laser welding or blazing.

Unlike the previous embodiment, there is no gap at edges in the current embodiment, and thus the light collecting efficiency can be further increased.

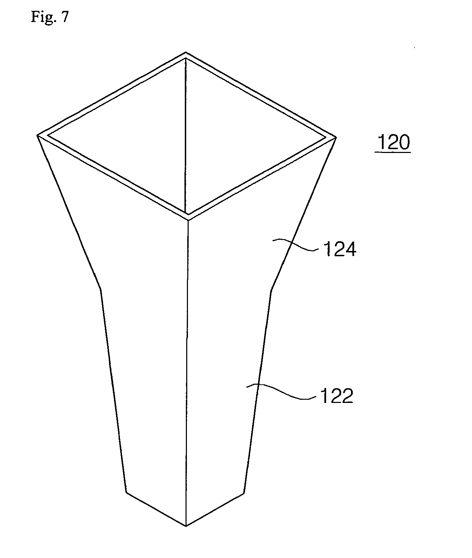

Referring to FIG. 7, the light collecting unit 120 is manufactured as a single body by using a die casting mold, and the reflectivity of the inner surface of the second light collecting part 124 can be increased through a post process, plating or polishing.

Furthermore, a glass mold may be used to form the light collecting unit 120 of glass as a single body, and then, a post process is performed such that the outer surface and the inner surface have different reflectivity values, that is, such that the refractivity of the inner surface is higher than the refractivity of the outer surface, so that total refection occurs between the outer and inner surfaces of each of the first and second light collecting parts 122 and 124.

In detail, like the principle of an optical fiber, when the inner surface of each of the first and second light collecting parts 122 and 124 has a higher refractivity than that of the inner surface, the inner surface having the higher refractivity functions as a core, and the outer surface having the lower refractivity functions as a cladding. Thus, light incident in the light collecting unit 120 is transmitted to the surface of the solar cell through the total reflection between the surface of the core and the surface of the cladding. Accordingly, collected light is transmitted without loss, and thus, the light collecting efficiency is maximized, and the output efficiency of the solar cell is significantly increased.

Cell Receiver 30

The cell receiver 30 includes the solar cell 34 configured to convert reflected and collected sunlight to an electrical signal, a pair of diodes 31 configured to rectify the electrical signal converted in the solar cell 34, the connectors 33 coupled with the electric wires configured to output the rectified electrical signal to the outside, and the substrate 32 to which the solar cell 34 and the diodes 31 are mounted and the connectors 33 are fixed.

The solar cell 34 includes a multi-layered cell that converts sunlight to an electrical signal without degradation in power efficiency even at a high temperature.

The substrate 32 may be formed by bonding a semiconductor substrate having excellent insulation characteristics to a metal substrate having excellent heat conductivity. For example, the semiconductor substrate may be formed of ceramic, and the metal substrate may be formed of copper.

Heat Dissipation Plate 40

The heat dissipation plate 40 supports the light collecting unit 20 and the cell receiver 30, and dissipates heat emitted from the substrate 32 of the cell receiver 30, together with the heat dissipation block 70 to be described later.

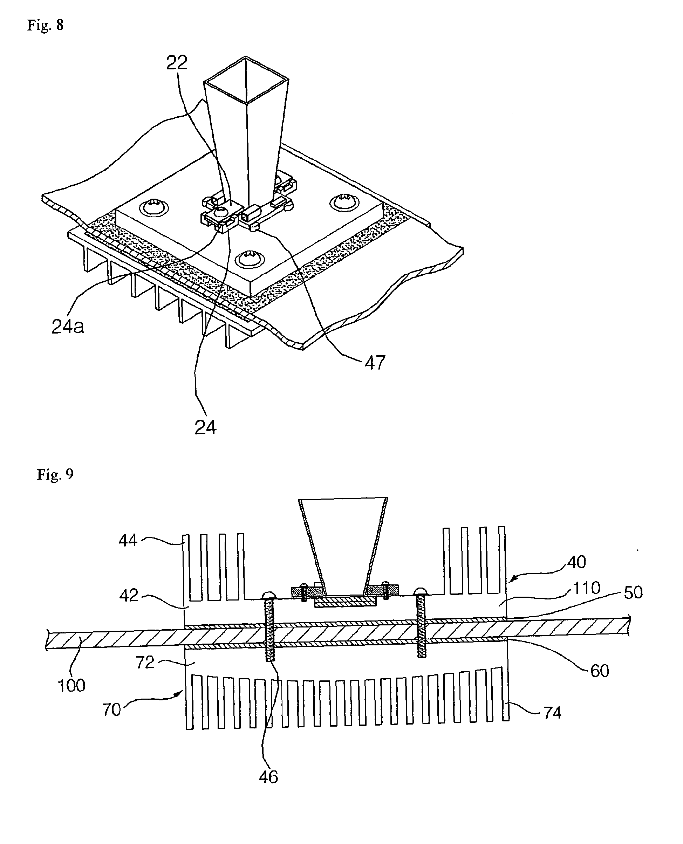

As illustrated in FIG. 1, the accommodation recess 45 for accommodating the cell receiver 30 is formed in the center of the upper surface of the heat dissipation plate 40. Alternatively, the accommodation recess 45 may be omitted. In this case, as illustrated in FIG. 8, guides 47 may be installed at positions corresponding to edges of the cell receiver 30 to accurately fix the cell receiver 30 to a desired position.

As such, the accommodation recess 45 or the guides 47 are formed to accurately fix the cell receiver 30 to a desired position, so that the degradation of the photovoltaic cell assembly due to a focus dislocation of sunlight can be prevented.

Referring to FIG. 8, when the guides 47 are installed, the substrate 32 of the cell receiver 30 protrudes from the heat dissipation plate 40 to form a step, and thus, supports 24 corresponding to the height of the step may be formed to support the clamps 22 from the lower side. For example, removal prevention protrusions 24a may be formed at four corners of the supports 24 to prevent the movement of the clamp 22.

Heat conducting grease may be applied to the bottom surface of the accommodation recess 45 of the heat dissipation plate 40 or to the inside of the heat dissipation plate 40 surrounded by the guides 47, to achieve efficient heat transfer.

Insertion holes 41 for inserting the bolts 46 are formed at the four corners of the heat dissipation plate 40.

Heat Dissipation Pads 50 and 60

The heat dissipation pad 50 is disposed at a contact boundary between the heat dissipation plate 40 and the housing 100 and the heat dissipation pad 60 is disposed at a contact boundary between the housing 100 and the heat dissipation block 70 to prevent air layers due to minute convexes and concaves. Alternatively, instead of the heat dissipation pads 50 and 60, heat dissipation grease may be used.

To remove air layers, the heat dissipation pad 50 is inserted between the heat dissipation plate 40 and the housing 100 and the heat dissipation pad 60 is inserted between the housing 100 and the heat dissipation block 70, and the heat dissipation plate 40 is securely coupled to the heat dissipation block 70 using the bolts 46, so that the heat transfer effect can be maximized. For example, the heat dissipation pads 50 and 60 may include silicon synthetic rubber.

Housing 100

The housing 100 protects the inside from an external force and efficiently dissipates heat due to light collecting, and is formed of a metal having excellent heat conductivity and excellent heat dissipation characteristics.

The housing 100 may have a hexahedron shape, and the Fresnel lens 110 is provided in plurality on the front surface of the housing 100 to collect incident sunlight, and the photovoltaic cell assembly corresponding to each of the Fresnel lenses 110 is installed on the bottom surface in the housing 100.

A plurality of vent holes are formed in a side surface of the housing 100, and a dust filter and a water proof filter may be attached to the vent holes to effectively allow air into or out of the housing 100 and prevent dust intrusion. A rainwater cover may be installed outside the vent holes to prevent ingress of rainwater.

Heat Dissipation Block 70

The heat dissipation block 70 includes a body 72 and heat dissipation fins 74, and is coupled to the heat dissipation plate 40 through the bolts 46 and fixed to the outside of the housing 100 as described above.

The heat dissipation plate 40 and the heat dissipation block 70 may constitute a heat dissipation module, and the structure of the heat dissipation module can be varied according to the present invention.

FIG. 9 is a cross-sectional view illustrating a heat dissipation module according to an embodiment of the present invention.

According to the current embodiment, the heat dissipation plate 40 includes a body 42 and a plurality of heat dissipation fins 44, and the light collecting unit 20 and the cell receiver 30 are installed at the inside of the heat dissipation plate 40 surrounded by the heat dissipation fins 44. The heat dissipation plate 40 is coupled with the heat dissipation block 70 through the bolts 46 with the housing 100 therebetween.

Accordingly, when the heat dissipation fins 44 are provided to the heat dissipation plate 40, heat transferred from the substrate 32 of the cell receiver 30 can be quickly dissipated to the outside before being transferred to the heat dissipation block 70. In addition, since only bolt holes in which the bolts 46 are inserted are formed in the housing 100, a water proof process can be facilitated.

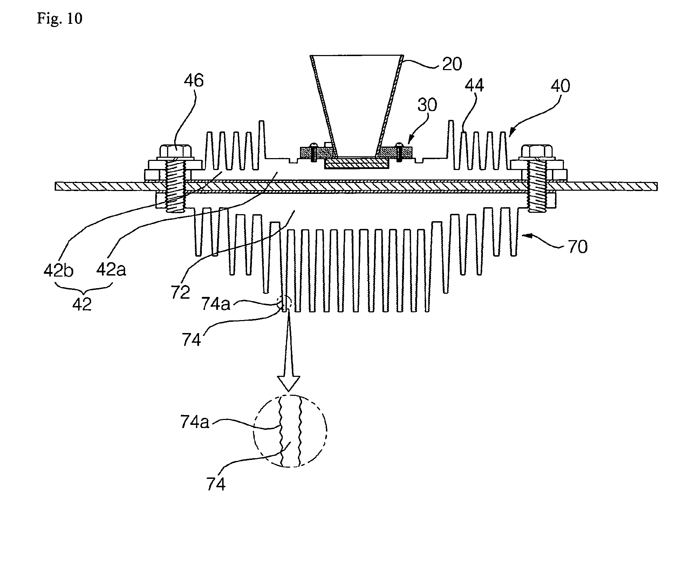

FIG. 10 is a cross-sectional view illustrating a heat dissipation module according to a modified example of FIG. 9.

According to the modified example, the body 42 of the heat dissipation plate 40 includes a portion 42a in which the cell receiver 30 is disposed, and a rest portion 42b thinner than the portion 42a, and thus, the body 42 has a stepped structure in cross-section. According to this structure, the body 42 of the heat dissipation plate 40 supporting the cell receiver 30 more efficiently absorbs heat.

The body 72 of the heat dissipation block 70 is formed in a stair shape from its edges, and the center portion corresponding to the cell receiver 30 is thickest. According to this structure, since the body 72 is formed in a stair shape from the edges, lateral wind that is not blocked by the heat dissipation fins 74 at the edges arrives at the heat dissipation fins 74 at the center portion, and thus, the heat dissipation effect is maximized. Furthermore, the thickest center portion efficiently absorbs heat.

Since the heat dissipation fins 44 of the heat dissipation plate 40 and the heat dissipation fins 74 of the heat dissipation block 70 become thinner to their ends, heat and pressure increase to the ends, and thus, heat dissipation to the ends is facilitated. Moreover, concave and convex structures 74a are formed on the surfaces of the heat dissipation fins 44 and 74, and thus, the surface areas are maximized to improve the heat dissipation effect.

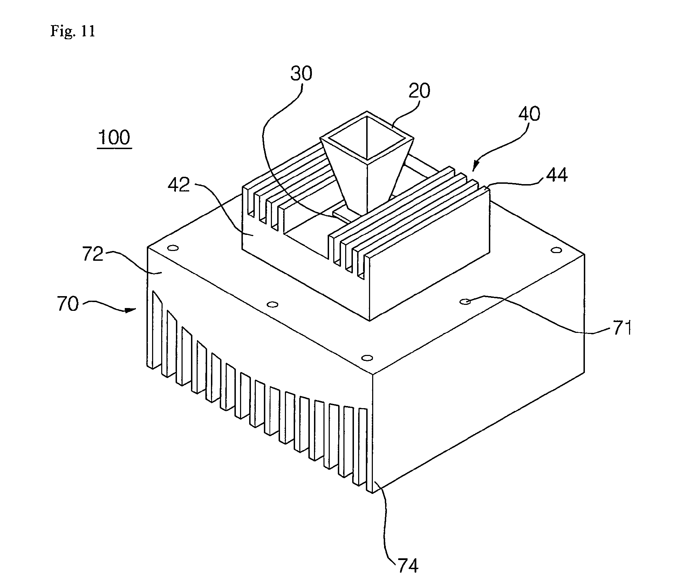

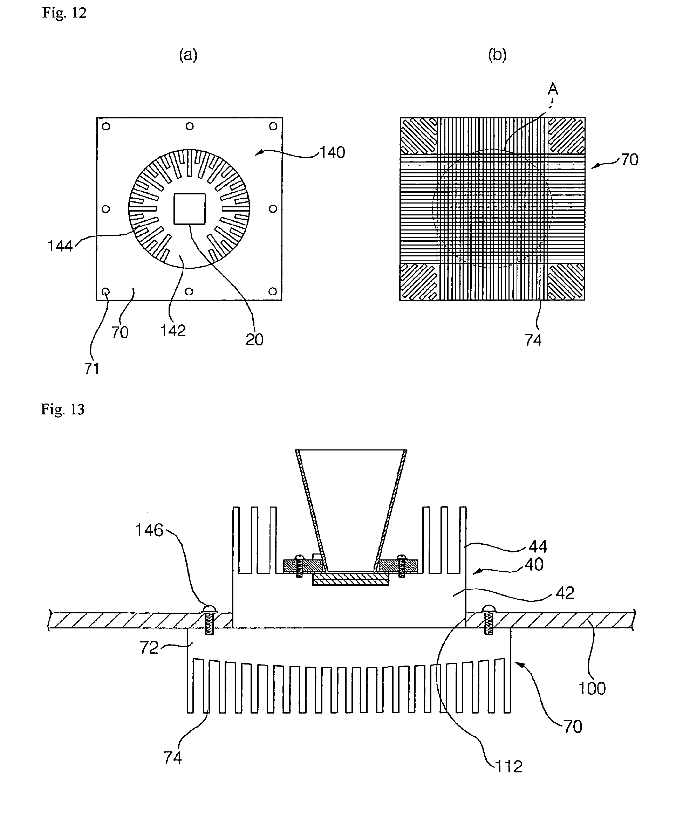

FIG. 11 is a perspective view illustrating a heat dissipation module according to an embodiment of the present invention, and FIG. 13 is a cross-sectional view illustrating the heat dissipation module of FIG. 11 coupled with a housing.

As shown in FIGS. 11 and 13, the heat dissipation module is a single body in which the heat dissipation plate 40 is integrally formed with the heat dissipation block 70. As described above, the heat dissipation plate 40 includes the body 42 and the heat dissipation fins 44, and the light collecting unit 20 and the cell receiver 30 are installed at the inside of the heat dissipation plate 40 surrounded by the heat dissipation fins 44.

Since the heat dissipation fins 44 of the heat dissipation plate 40 and the heat dissipation fins 74 of the heat dissipation block 70 increase contact areas with air and maximize the heat dissipation effect, the load of a photovoltaic cell due to light collecting and heat collecting is reduced, and the efficiency of the photovoltaic cell is increased, and the service life of the photovoltaic cell is extended. The shapes, thicknesses, heights, arrangements, and distances of the heat dissipation fins 44 and 74 can be adjusted according to characteristics of photovoltaic devices. FIGS. 12A and 12B are schematic views illustrating heat dissipation fins of a heat dissipation plate and heat dissipation fins of a heat dissipation block according to an embodiment of the present invention.

FIG. 12A is a plan view illustrating a heat dissipation module. Referring to FIG. 12, a heat dissipation plate 140 includes a cylindrical body 142 and a plurality of heat dissipation fins 144 disposed on the body 142 and extending in the radial direction about the cell receiver 30. FIG. 12B is a bottom view illustrating the heat dissipation module. Referring to FIG. 12B, the heat dissipation fins 74 of the heat dissipation block 70 may have a lattice shape in an adjacent region (refer to A of FIG. 12B) corresponding to the cell receiver 30.

According to this structure, the heat dissipation fins 144 are arrayed on the heat dissipation plate 140 in a manner of transferring heat from the center of a heat collecting portion to the edge thereof, and the heat dissipation fins 74 are arrayed in lattice at a heat collecting portion on the heat dissipation block 70 to increase the density of the heat dissipation fins 74, so that, the heat dissipation effect can be maximized.

Referring to FIGS. 11 and 13, a plurality of bolt holes 71 are arrayed along the upper edges of the body 72 of the heat dissipation block 70. An opening 112 corresponding to the size of the heat dissipation plate 40 is formed in the housing 100. The heat dissipation plate 40 is inserted in the opening 112 from the lower side of the housing 100, and then, bolts 146 are fitted in the bolt holes 71 to fix the heat dissipation block 70 to the housing 100. At this point, a heat dissipation pad may be interposed between the surface of the housing 100 and the surface of the heat dissipation block 70, or heat dissipation grease may be applied therebetween to maximize the heat conductivity.

Referring again to FIG. 11, the thickness of the body 72 of the heat dissipation block 70 is maximized at the portion corresponding to the cell receiver 30, and decreases toward both edges. According to this structure, heat is effectively absorbed at the portion corresponding to the cell receiver 30, that is, at the heat collecting portion to maximize the thermal efficiency.

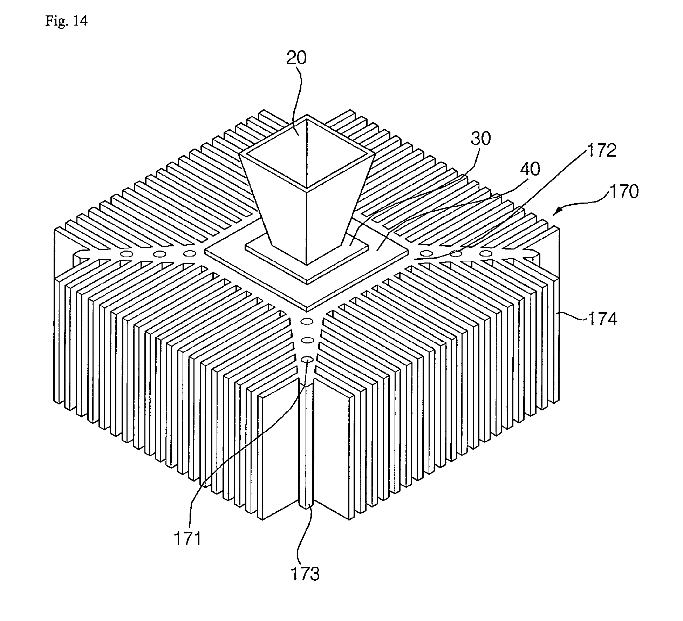

FIG. 14 is a perspective view illustrating a heat dissipation module according to an embodiment of the present invention.

According to the current embodiment, the heat dissipation plate 40 has no heat dissipation fin, and a heat dissipation block 170 integrally formed with the heat dissipation plate 40 includes a body 172 and heat dissipation fins 174. The body 172 includes extension protrusions 173 extending outward from four corners. The heat dissipation fins 174 extend from the body 172 and the extension protrusions 173.

According to this structure, since a larger number of the heat dissipation fins 174 are provided to the heat dissipation block 170, the heat dissipation efficiency can be improved.

According to the current embodiment, the heat dissipation module can be fixed to the housing 100 using bolt holes 171 formed in the body 172 or the extension protrusions 173, like the embodiment of FIG. 11.

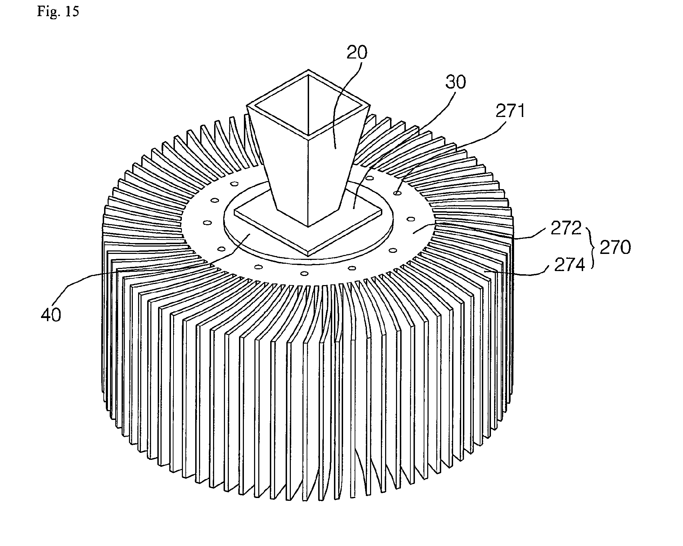

FIG. 15 is a perspective view illustrating a heat dissipation module according to another embodiment of the present invention.

According to the current embodiment, the heat dissipation plate 40 is circular, and a heat dissipation block 270 includes a cylindrical body 272 and heat dissipation fins 274 extending in spiral shape from the outer circumference surface of the cylindrical body 272.

According to this structure, the heat dissipation fins 274 of the heat dissipation block 270 are formed in spiral shape to maximize a heat dissipation area and the heat dissipation efficiency.

According to the current embodiment, the heat dissipation module can be fixed to the housing 100 using bolt holes 271 formed in the body 272 or the extension protrusions 173, like the embodiment of FIG. 11.

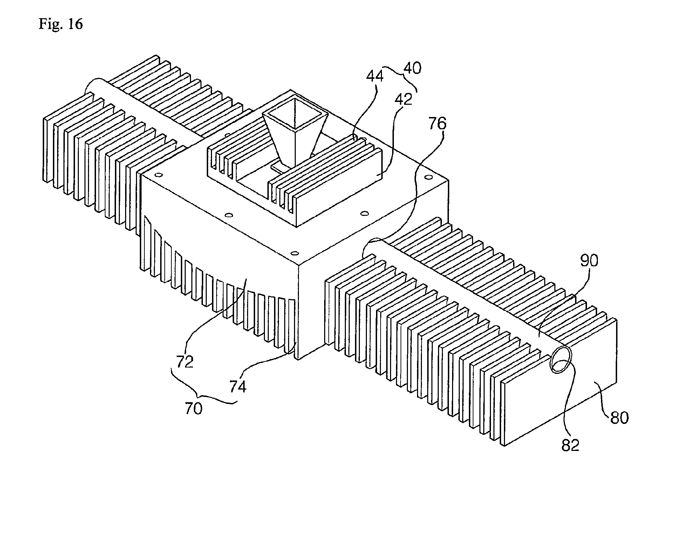

FIG. 16 is a perspective view illustrating a heat dissipation module according to another embodiment of the present invention.

According to the current embodiment, a through hole 76 passes through facing side surfaces constituting the body 72 of the heat dissipation block 70 illustrated in FIG. 11, and a heat pipe 90 is inserted in the through hole 76, and both ends of the heat pipe 90 are exposed along predetermined lengths.

Heat dissipation fins 80 are attached to exposed portions of the heat pipe 90. Contact portions 82 of the heat dissipation fins 80 contacting the heat pipe 90 are cut out in the same shape as that of the heat pipe 90 to receive the heat pipe 90.

The heat pipe 90 is formed of copper or aluminum, and air-tightly accommodates solvent such as water, ammonia, or acetone. When a surface of the heat pipe 90 is heated, the solvent is boiled, and a vapor pressure causes heat to be quickly transferred to the heat dissipation fins 80 and dissipated.

According to this structure, collected heat is absorbed by the heat pipe 90 and is more efficiently dissipated through the heat dissipation fins 80.

Although one light collecting module is illustrated in FIG. 16, since a plurality of light collecting modules are arrayed on a typical photovoltaic device, heat pipes installed respectively on the light collecting modules may communicate with one another in a line unit.

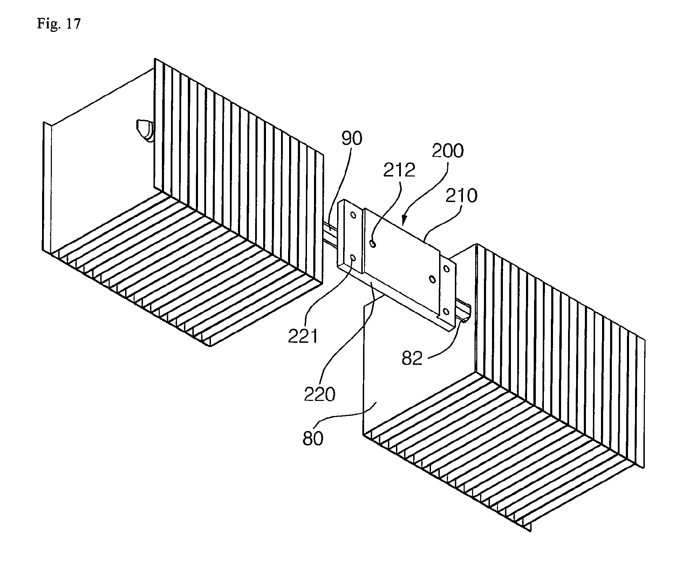

FIG. 17 is a perspective view illustrating a modified example of FIG. 16.

According to the modified example, instead of a heat dissipation plate and a heat dissipation block, a single heat sink block 200 is provided, and the heat pipe 90 is attached through welding to the inner surface of the heat sink block 200. In addition, the heat dissipation fins 80 have through holes 82 that have a size to allow the heat pipe 90 to pass through the through holes 82, and the heat dissipation fins 80 are spaced a constant distance from one another and fitted on the heat pipe 90.

The heat sink block 200 includes an upper body 210 having a size corresponding to the opening 112 of the housing 100, and a lower body 220 that is wider than the upper body 210. The upper body 210 has screw holes 212 for fixing the clamps 22 configured to fix the light collecting unit 20, and the lower body 220 has bolt holes 221 for fixing the heat sink block 200 to the housing 100.

Accordingly, the upper body 210 is fitted in the housing 100 from the lower side, and then, bolts are fitted in the bolt holes 221 from the inside of the housing 100 to fix the heat sink block 200 to the housing 100.

Furthermore, a cooling fan may be attached to the heat dissipation fins of the heat dissipation block or the heat sink block according to the above-described embodiments, so that, heat can be more quickly dissipated from the heat dissipation fins.

According to the embodiments, sunlight is efficiently converted to an electrical signal, and heat generated during the conversion is quickly and effectively dissipated, so that, the photovoltaic cell assembly can be usefully applied to photovoltaic cell industries using sunlight to generate electricity.

While the present invention has been described in detail, it should be understood that various changes, substitutions and alterations can be made hereto without departing from the spirit and scope of the invention as defined by the appended claims.

## Claims

1. A photovoltaic cell assembly comprising:
a light collecting unit configured to collect sunlight incident from a Fresnel lens;
a cell receiver configured to convert the sunlight collected by the light collecting unit to an electrical signal;
a heat dissipation plate configured to support the light collecting unit and the cell receiver and fixed to an inner surface of a housing; and
a heat dissipation block disposed on an outer surface of the housing and coupled to the heat dissipation plate with the housing interposed between the heat dissipation plate and the heat dissipation block.

2. The photovoltaic cell assembly of claim 1, wherein the cell receiver comprises:
a cell configured to convert the sunlight to the electrical signal;
a pair of diodes configured to rectify the electrical signal converted at the cell;
a pair of connectors configured to output the rectified electrical signal to an outside; and
a substrate to which the cell and the diode are mounted and the connector is fixed.

3. The photovoltaic cell assembly of claim 2, wherein the substrate is configured by bonding a semiconductor substrate and a metal substrate to each other.

4. The photovoltaic cell assembly of claim 3, wherein the semiconductor substrate is formed of ceramic, and the metal substrate is formed of copper.

5. The photovoltaic cell assembly of claim 1, wherein a heat dissipation pad is interposed or heat conducting grease is applied between the heat dissipation plate and the housing and between the housing and the heat dissipation block.

6. The photovoltaic cell assembly of claim 1, wherein an accommodation recess is formed in a center of an upper surface of the heat dissipation plate, and the cell receiver is accommodated in the accommodation recess.

7. The photovoltaic cell assembly of claim 1, wherein a plurality of guides are disposed in a center of an upper surface of the heat dissipation plate and protrude at positions corresponding to edges of the cell receiver, and the cell receiver is disposed in a region formed by the guides.

8. The photovoltaic cell assembly of claim 1, wherein flanges are disposed at a lower end of the light collecting unit and protrude outward from both sides of the light collecting unit, and clamps respectively overlap upper portions of the flanges, and the clamp is fixed to the heat dissipation plate through a bolt.

9. The photovoltaic cell assembly of claim 2, wherein flanges are disposed at a lower end of the light collecting unit and protrude outward from both sides of the light collecting unit, and clamps respectively overlap upper portions of the flanges, and the clamp is fixed to the heat dissipation plate through a bolt, and
one of the clamps covers and presses the connector and an electric wire connected to the connector.

10. The photovoltaic cell assembly of claim 1, wherein a plurality of guides are disposed in a center of an upper surface of the heat dissipation plate and protrude at positions corresponding to edges of the cell receiver, and the cell receiver is disposed in a region formed by the guides, and
flanges are disposed at a lower end of the light collecting unit and protrude outward from both sides of the light collecting unit, and the flanges are supported respectively by supports disposed between the flanges and the heat dissipation plate, and clamps respectively overlap upper portions of the flanges, and the clamp is fixed to the heat dissipation plate through a bolt.

11. A photovoltaic cell assembly comprising:
a light collecting unit configured to collect sunlight incident from a Fresnel lens;
a cell receiver configured to convert the sunlight collected by the light collecting unit to an electrical signal;
a heat dissipation plate configured to support the light collecting unit and the cell receiver; and
a heat dissipation block integrally formed with the heat dissipation plate and disposed outside a housing,
wherein the heat dissipation plate and the heat dissipation block each includes a body and a plurality of heat dissipation fins protruding from the body, and a size of the heat dissipation plate is smaller than a size of the heat dissipation block, and the heat dissipation plate is fitted in an opening having a size corresponding to the size of the heat dissipation plate and formed in the housing such that the heat dissipation block is fixed to the housing.

12. The photovoltaic cell assembly of claim 11, wherein the heat dissipation fin of the heat dissipation plate extends in a radial direction about the cell receiver, and
the heat dissipation fin of the heat dissipation block is formed in a lattice shape at a portion corresponding to the cell receiver.

13. The photovoltaic cell assembly of claim 11, wherein a plurality of bolt holes are arrayed along an edge of the heat dissipation block, and the heat dissipation block is fixed to the housing through a bolt fitted from an inner surface of the housing to the bolt hole.

14. The photovoltaic cell assembly of claim 11, further comprising heat dissipation fins extending outward from side surfaces of the heat dissipation block.

15. The photovoltaic cell assembly of claim 11, wherein the heat dissipation block is thickest at a portion corresponding to the cell receiver, and decreases in thickness toward both edges from the portion corresponding to the cell receiver.

16. The photovoltaic cell assembly of claim 11, further comprising a cooling fan installed on the heat dissipation fin of the heat dissipation block.

17. The photovoltaic cell assembly of claim 11, wherein a through hole passes through side surfaces constituting the heat dissipation block and facing each other,
a heat pipe is inserted in the through hole, and
a heat dissipation fin is attached to a portion constituting the heat pipe and exposed from the through hole.

18. The photovoltaic cell assembly of claim 1, wherein the light collecting unit comprises:
a barrel-shaped first light collecting part fixed onto the cell receiver; and
a second light collecting part extending from the first light collecting part to the lens,
wherein an expansion angle of the second light collecting part from an optical axis of the lens is greater than that of the first light collecting part.

19. The photovoltaic cell assembly of claim 18, wherein a focus of the lens is disposed in a boundary between the first and second light collecting parts.

20. The photovoltaic cell assembly of claim 18, wherein the expansion angle of the second light collecting part ranges from about 28° to about 30° from the optical axis.

21. The photovoltaic cell assembly of claim 1, wherein the light collecting unit comprises:
a barrel-shaped first light collecting part increasing in horizontal cross section from a lower end to an upper end along a first inclination angle; and
a barrel-shaped second light collecting part bonded to the upper end of the first light collecting part and increasing in horizontal cross section along a second inclination angle greater than the first inclination angle.

22. The photovoltaic cell assembly of claim 1, wherein the light collecting unit comprises:
a tetragonal barrel-shaped first light collecting part increasing in horizontal cross section from a lower end to an upper end along a first inclination angle; and
a second light collecting part integrally extending respectively from surfaces at the upper end of the first light collecting part at a second inclination angle greater than the first inclination angle.

23. The photovoltaic cell assembly of claim 1, wherein the light collecting unit comprises:
a barrel-shaped first light collecting part increasing in horizontal cross section from a lower end to an upper end along a first inclination angle; and
a barrel-shaped second light collecting part extending from the upper end of the first light collecting part and increasing in horizontal cross section along a second inclination angle greater than the first inclination angle,
wherein the first and second light collecting parts form a single body.

24. The photovoltaic cell assembly of claim 1, wherein the light collecting unit comprises:
a barrel-shaped first light collecting part increasing in horizontal cross section from a lower end to an upper end along a first inclination angle; and
a barrel-shaped second light collecting part extending from the upper end of the first light collecting part and increasing in horizontal cross section along a second inclination angle greater than the first inclination angle,
wherein the first and second light collecting parts form a single body, and
a total reflection occurs between inner and outer surfaces of the first and second light collecting parts.

25. The photovoltaic cell assembly of claim 24, wherein the first and second light collecting parts are formed of glass, and
the inner surfaces respectively of the first and second light collecting parts have higher refractivity values than those of the outer surfaces.

26. The photovoltaic cell assembly of claim 11, wherein the heat dissipation plate comprises a body having a portion that supports the cell receiver and is thicker than a rest portion, and
the heat dissipation block comprises a body having a plurality of steps that are formed from an edge, and the body is thickest at a portion corresponding to the cell receiver.

27. The photovoltaic cell assembly of claim 11, wherein the heat dissipation fins of the heat dissipation plate and the heat dissipation block decrease in thickness toward ends of the heat dissipation fins.

28. The photovoltaic cell assembly of claim 11, wherein the heat dissipation fins of the heat dissipation plate and the heat dissipation block have surfaces with concave and convex structures.

29. A photovoltaic cell assembly comprising:
a light collecting unit configured to collect sunlight incident from a Fresnel lens;
a cell receiver configured to convert the sunlight collected by the light collecting unit to an electrical signal;
a heat sink block including an upper body configured to support the light collecting unit and the cell receiver, and a lower body integrally formed with the upper body and disposed outside a housing; and
a heat pipe coupled to the heat sink block and provided with a plurality of heat dissipation fins that are spaced a constant distance from one other and are fitted in and fixed to the heat pipe,
wherein a size of the upper body is smaller than a size of the lower body, and the upper body is fitted in an opening having a size corresponding to the size of the upper body and formed in the housing such that the heat sink block is fixed to the housing.
